# EUROPEAN PATENT SPECIFICATION

(11) **EP 3 595 105 B1**
(45) Date of publication and mention of the grant of the patent: **24.01.2024**
(21) Application number: 18183520.8
(22) Date of filing: 13.07.2018
(51) Int. Cl.: H02B 1/56, H02G 5/10

(54) **A HEAT SINK FOR A HIGH VOLTAGE SWITCHGEAR**
KÜHLKÖRPER FÜR EIN HOCHSPANNUNGS-SCHALTGERÄT
DISSIPATEUR DE CHALEUR POUR DISPOSITIF DE COMMUTATION HAUTE TENSION

(43) Date of publication of application: 15.01.2020
(73) Proprietor: ABB Schweiz AG, 5400 Baden (CH)
(72) Inventor: Blaz, Michael, 38116 Braunschweig (DE); Baier, Oliver, 40489 Düsseldorf (DE); Cortinovis, Gianluca, 24021 Albino (IT)
(74) Representative: Maiwald GmbH

(56) References cited:
- EP-A1- 3 273 557
- EP-A2- 1 248 506
- CN-A- 106 207 915
- DE-A1-102016 113 351
- JP-A- 2011 200 043
- US-A1- 2005 269 069
- US-A1- 2009 310 312
- US-A1- 2010 212 875
- US-A1- 2015 316 294

## Description

### FIELD OF THE INVENTION

The present invention relates to a heat sink for a high voltage switchgear, and to medium or high voltage switchgear.

### BACKGROUND OF THE INVENTION

Medium and/or high voltage parts, for example of a medium voltage or high voltage switchgear need to be cooled with an external heat sink made of an electrically conductive material. Heat sinks are mounted on the parts that need to be cooled, where the heat sinks have bodies with fins on the outside that have rounded edges to reduce electric stress at these edges. The fins are normally quite thin, and therefore these edges have small radii. At the small radii, enhancement of electric field occurs, which decreases the dielectric properties. To mitigate this, to avoid discharges an insulating layer is frequently applied to the stressed areas of the heatsink. This layer, with a higher discharge voltage than the gaseous insulating material around the setup, serves to increase the dielectric performance. However, the discharge voltage of the setup is reduced due to the field enhancement at the small radii points of the heatsink. Even with a solid insulation layer over these radii, the weak points are the radii or rather the areas with a solid insulation ends.

EP3273557A1 describes an electrical joint that includes a first conductive component, a second conductive component, and a thermal cooling interface positioned between the first and second conductive components , the thermal cooling interface including a base plate coupled to the first conductive component, and a plurality of walls extending orthogonally from the base plate towards the second conductive component, the plurality of walls defining a plurality of cooling channels that channel air therethrough to facilitate cooling the first and second conductive components, wherein the first conductive component, the thermal cooling interface, and the second conductive component are electrically coupled in series.

DE102016113351A1 describes a device for cooling an electrical circuit breaker in a control cabinet, comprising a cooler with a heat sink, which is connected in a thermally conductive manner to the electrical circuit breaker, and further comprises a chimney-like fume cupboard extending in the vertical direction and a heat pipe which is thermally conductively connected to the heat sink and extends from the heat sink into the chimney-type fume cupboard extends into and on which cooling fins arranged in the interior of the chimney-like extractor are provided.

CN106207915A describes a fully-enclosed composite resin casting busbar slot, which includes a busbar conductor and a composite resin body. The number of the busbar conductor is three, and the three busbar conductors are all wrapped by the composite resin body and are covered by the composite resin body. A hollow rectangular through ring is provided inside the composite resin body. The first through hole and the second through hole which are symmetrical up and down and the rectangular through ring are arranged to make the interior of the composite resin body communicate up and down, which is described as being beneficial to the heat dissipation inside the busbar slot. The first heat sink and the second heat sink allow the heat inside the composite resin body to be quickly transferred into the rectangular through ring, and then discharged into the air through the first through hole and the second through hole, thereby increasing the heat dissipation effect of the bus bar. It is described that by providing the first groove and the second groove, the contact area between the composite resin body and the air is increased, which is more conducive to the heat dissipation of the busbar slot, thereby ensuring the service life of the busbar slot.

EP1248506A2 describes a heat sink for cooling a component. The component may be one of several components on a circuit board. The heat sink includes a tubular body and a plurality of internal fins. The tubular body has an interior surface and an exterior surface. At least a portion of the exterior surface being substantially flat. The plurality of internal fins extend from the internal surface and are generally symmetric around a center line of the tubular body. The substantially flat portion of the tubular body contacts the component to remove heat from the component. The heat sink may further include a plurality of exterior fins extending from the exterior surface of the tubular body. Heating units generate heat to heat a pan or other utensil placed on a glass-ceramic plate and are controlled by a circuit board that is retained in a housing unit with a heat sink assembly. The heating units may be shaped as a square pan to allow air to circulate within the housing unit, that does not need a fan to force air through it. US2010/212875A1 describes a tubular heat dispersing structure which utilizes tubular channel to contact with the heat source(s) and the heat conductor for restricting the heated air. When the flowing air flows into the channel, it is to produce the flowing naturally, and the heated air flows toward the opening rapidly. Therefore, the structure can form air flowing actively for achieving the heat dispersing effect. Besides, the structure also can have varied geometric shapes and sizes for corresponding to different shapes of different heat sources and heat conductors, so that a better stacked attachment therebetween can be achieved, thereby saving the cost of building the molds and corresponding to the heat dispersing requirements of various power. US2009/310312A1 describes an electronics enclosure. The electronics enclosure includes a heat dissipating body comprising: a heat conducting surface, a first flange adjacent to the heat conducting surface, and a first part of a latch mechanism adjacent to the heat conducting surface. The first part of the latch mechanism is adjacent an edge of the heat conducting surface opposite to the first flange, such that a portion of the heat conducting surface is between the first flange and the first part of the latch mechanism. The electronics enclosure also includes a plurality of electronic modules configured to mount to the heat dissipating body. Each of the plurality of electronic modules comprises: a plurality of electronic components, a heat conducting side configured to contact the heat conducting surface of the heat dissipating body, a second flange adjacent the heat conducting side, the second flange configured to couple with the first flange, and a second part of the latch mechanism adjacent the heat conducting side, the second part of the latch mechanism configured to couple with the first part of the latch mechanism. The second flange and the second part of the latch mechanism are on opposite edges of the heat conducting side. US2005/269069A1 provides an improved heat exchange apparatus including multi-ported heat exchanger tubing with improved heat chamber characteristics. The documents discloses internal channels at least a partial curved shape and with the internal surface comprising fins.

Accordingly, there is a need to improve heat sinks for use in such circumstances.

### SUMMARY OF THE INVENTION

Therefore, it would be advantageous to have an improved technology for providing a heat sink for a medium voltage or high voltage switchgear.

The object of the present invention is solved with the subject matter of the independent claims, wherein further embodiments are incorporated in the dependent claims. It should be noted that the following described aspects of the invention apply also for the heat sink and for the switchgear having at least one heat sink.

Appended claim 1 derfines a heat sink for a high voltage switchgear. Appended claim 12 defines a medium or high voltage switchgear including the heat sink defined in claim 1. The invention and its scope of protection is defined by these independent claims. The following examples of the disclosure provide examples of how technical subject matters can be combined.

According to the invention, there is provided a heat sink for a high voltage switchgear, the heat sink comprising a body. The body is centred around a central axis that extends in an axial direction from a first outer surface of the body to a second outer surface of the body. At least one third outer surface of the body extends from the first outer surface to the second outer surface. At least one air channel extends through the body from the first outer surface to the second outer surface. The at least one air channel is surrounded by the at least one third outer surface.

In this manner, the heat sink not only cools through radiative cooling from the outer surface, but provides for increased cooling through the dissipation of convective heat through the internal parts of the heat sink. This enables improved cooling capability, taking heat away from critical locations, such as the pole part, and connection and contact points within a switchgear for example. Thus, an increase in contact resistance due to generated heat is mitigated via the effective dissipation of heat from the new sink design with internal cooling capabilities.

Thus, medium and high voltage parts, such as of a switchgear, can be cooled by an external heat sink. In an example, the heat sink is made from an electrically conductive material.

According to the invention, the at least one air channel comprises a ribbed surface.

In other words, the heat sink has internal ribbing in order to provide for increased efficiency of convective cooling from the inside of the heat sink.

According to the invention, the ribbed surface extends from the first outer surface to the second outer surface.

In an example, the ribbed surface comprises fins that extend in the axial direction.

In an example, the at least one air channel comprises an air channel extending down the central axis of the body.

According to the invention, the at least one air channel comprises at least one arcuate air channel. According to the invention, the at least one arcuate air channel has a radius of curvature centred along the central axis.

In an example, the at least one arcuate air channel comprises a plurality of air channels. Each of the plurality of air channels has a different radius of curvature centred along the central axis

In this way, manufacture of the heat sink is facilitated and increased cooling capability is provided.

In an example, at least a part of a junction between the at least one third outer surface and the first outer surface has a convex rounded portion.

In an example, at least a part of a junction between the at least one third outer surface and the second outer surface has a convex rounded portion.

In this manner, the heat sink can have a smooth outer geometry, with rounded edges at the faces that can have a large radius. This smooth surface reduces the electric field strength at the surface of the heat sink, and therefore increases the dielectric performance. This is facilitated, because the surface(s) of the heat sink used for the dissipation of heat are located internally within the heat sink that open to the surface, facilitating convective cooling, but with the internal cooling channels being shielded against the electric field by the outer contour of the heat sink, that for example can be cylindrically shaped.

In an example, the at least one third outer surface comprises a flat portion. The flat portion is configured to be mounted to one or more components of a high voltage switchgear.

Thus, the heat sink can be easily mounted at appropriate points in a system such as a switchgear, such as the pole part, and all connection and contact points.

In an example, the at least one third outer surface has a substantially cylindrical shape, with a radius of curvature centred along the central axis.

In an example, the radius of curvature of the substantially cylindrical shape is selected such that in operation the electric field strength at the at least one third outer surface is minimised.

In an example, the body is made from Aluminium.

In an example, the body is made by hollow extrusion.

In an example, the at least one third outer surface comprises a ribbed surface.

In a second aspect, there is provided a medium or high voltage switchgear comprising at least one heat sink according to the invention.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
- Fig. 1: shows a schematic representation of an example of a heat sink;
- Fig. 2: shows a detailed example of a heat sink; and
- Fig. 3: shows a shows the electric field strength at the cylindrical surface of the heat sink of Fig. 2.

### DETAILED DESCRIPTION OF EMBODIMENTS

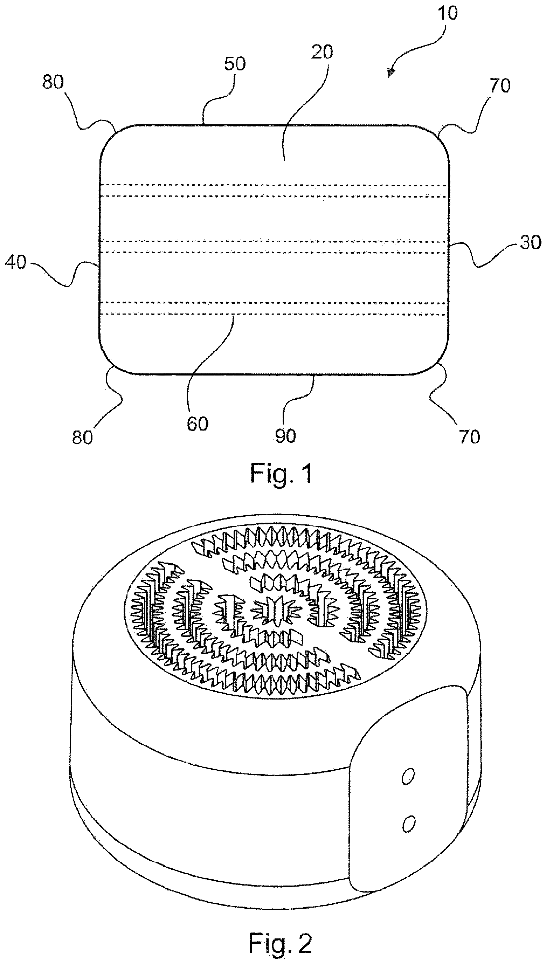

Fig. 1 shows an example of a heat sink 10 for a high voltage switchgear, where optional features are shown in dashed lines. The heat sink 10 comprises a body 20. The body is centred around a central axis that extends in an axial direction from a first outer surface 30 of the body to a second outer surface 40 of the body. At least one third outer surface 50 of the body extends from the first outer surface to the second outer surface. At least one air channel 60 extends through the body from the first outer surface to the second outer surface. The at least one air channel is surrounded by the at least one third outer surface.

According to the invention, the at least one air channel comprises a ribbed surface.

According to the invention, the ribbed surface extends from the first outer surface to the second outer surface.

According to an example, the ribbed surface comprises fins that extend in the axial direction.

According to an example, the at least one air channel comprises an air channel extending down the central axis of the body.

According to the invention, the at least one air channel comprises at least one arcuate air channel.

According to the invention, the at least one arcuate air channel has a radius of curvature centred along the central axis.

According to an example, the at least one arcuate air channel comprises a plurality of air channels, wherein each of the plurality of air channels has a different radius of curvature centred along the central axis.

According to an example, at least a part of a junction 70 between the at least one third outer surface and the first outer surface has a convex rounded portion.

According to an example, at least a part of a junction 80 between the at least one third outer surface and the second outer surface has a convex rounded portion.

In an example, the rounded portion has a large radius of curvature. In an example, the radius of curvature is larger than a dimension of the body.

According to an example, the at least one third outer surface comprises a flat portion 90. The flat portion is configured to be mounted to one or more components of a high voltage switchgear.

In an example, the body at the position of the flat portion has at least one threaded hole extending into the interior of the body. In an example, the at least one threaded hole has at least one central axis perpendicular to the flat portion.

According to an example, the at least one third outer surface has a substantially cylindrical shape, with a radius of curvature centred along the central axis.

According to an example, the radius of curvature of the substantially cylindrical shape is selected such that in operation the electric field strength at the at least one third outer surface is minimised.

According to an example, the body is made from Aluminium.

According to an example, the body is made by hollow extrusion.

According to an example, the at least one third outer surface comprises a ribbed surface.

In an example, the ribbed surface comprises fins that extend in the axial direction.

Reference to air channel above relates to a channel that could allow air to flow through it, but in certain situations gases other than air can be utilized in apparatuses and the skilled person would appreciate that the channel is suitable for convective cooling flow relating to these other gases in addition to air.

One or more of the heat sinks described with respect to Fig. 1 can be used to cool appropriate parts of a medium or high voltage switchgear.

The heat sink of Fig. 1 is described in more detail with reference to figs. 2-3.

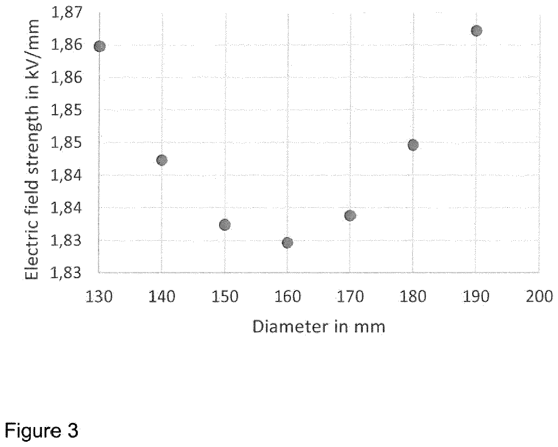

Figur 2 shows in detail a heat sink with inner fins or ridges or ribs. The heatsink is made of Aluminium, which has a cylindrical outer shape with rounded edges joining the cylindrical part to two flat faces. The rounded edges have large radii that reduce the field enhancement at the outer surface of the heatsink in comparison to other heatsinks that have features such as fins with small radii on the outer surface of the sink. Therefore the dielectric performance of the heatsink can be increased. Furthermore, the diameter of the heat sink can be chosen for a particular implementation such that the electric field at the outer surface of the heatsink reaches a minimum, when a distance from the centre of the heatsink to a grounded part of the switchgear is fixed. This is shown in Fig.3 which plots the electric field strength at the cylindrical surface for a fixed distance of 225 mm between the centre axis of the heatsink and a grounded wall for an applied voltage of 170 kV.

Continuing with Fig. 2 the fins for heat dissipation are located inside the cylindrical heatsink, providing sufficient surface for heat dissipation without the need for small radii at the outer contour of the heatsink where the electric stresses the highest. Heat is dissipated, in the new design, due to thermal convection of gas along the inner fins, with radiative cooling and convective cooling also being provided due to radiation emission from the outer surface and air flow over the outer surface. However, cooling is augmented through provision of the inner fins, whilst at the same time increasing the dielectric performance. The inner fins are also partly shielded against the electric field, and therefore do not lead to a strong enhancement of the electric field. Furthermore, the geometry of the heatsink lends itself to manufacture by hollow extrusion providing for inexpensive production. In this way, cost per heatsink can be reduced compared to normal heatsinks made for example Aluminium through pressure casting.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

In the claims, the word "comprising" does not exclude other elements or steps, and the indefinite article "a" or "an" does not exclude a plurality. Any reference signs in the claims should not be construed as limiting the scope.

Fig. 3 displays the electric field strength at the cylindrical surface for a fixed distance between center point of the heat sink, and grounded wall of 225 mm and an applied voltage of 170 kV. Such calculation is done with utilization factor by Schwaiger.

## Claims

1. A heat sink (10) for a high voltage switchgear, the heat sink is configured to cool medium and high voltage parts of the switchgear and the heat sink is made from an electrically conductive material and comprises:
a body (20);
wherein, the body is centred around a central axis that extends in an axial direction from a first outer surface (30) of the body to a second outer surface (40) of the body;
wherein, at least one third outer surface (50) of the body extends from the first outer surface to the second outer surface; and
wherein, at least one air channel (60) extends through the body from the first outer surface to the second outer surface and is located within the body, wherein the at least one air channel is surrounded by the at least one third outer surface, wherein the at least one air channel comprises a ribbed surface, wherein the ribbed surface extends from the first outer surface to the second outer surface;
wherein the at least one air channel comprises at least one arcuate shaped air channel; and
wherein the at least one arcuate air channel has a radius of curvature centred along the central axis.

2. Heat sink according to claim 1, wherein the ribbed surface comprises fins that extend in the axial direction.

3. Heat sink according to any of claims 1-2, wherein the at least one air channel comprises an air channel extending down the central axis of the body.

4. Heat sink according to any of claims 1-3, wherein the at least one arcuate air channel comprises a plurality of air channels, wherein each of the plurality of air channels has a different radius of curvature centred along the central axis.

5. Heat sink according to any of claims 1-4, wherein at least a part of a junction (70) between the at least one third outer surface and the first outer surface has a convex rounded portion.

6. Heat sink according to any of claims 1-5, wherein at least a part of a junction (80) between the at least one third outer surface and the second outer surface has a convex rounded portion.

7. Heat sink according to any of claims 1-6, wherein the at least one third outer surface comprises a flat portion (90), wherein the flat portion is configured to be mounted to one or more components of a high voltage switchgear.

8. Heat sink according to any of claims 1-7, wherein the at least one third outer surface has a substantially cylindrical shape, with a radius of curvature centred along the central axis.

9. Heat sink according to any of claims 1-8, wherein the body is made from Aluminium.

10. Heat sink according to any of claims 1-9, wherein the body is made by hollow extrusion.

11. Heat sink according to claim 10, wherein the at least one third outer surface comprises a ribbed surface.

12. A medium or high voltage switchgear comprising at least one heat sink according to any of claims 1-11.

## Patentansprüche

1. Kühlkörper (10) für ein Hochspannungs-Schaltgerät, wobei der Kühlkörper dazu ausgelegt ist, Mittel- und Hochspannungsteile des Schaltgeräts zu kühlen, und der Kühlkörper aus einem elektrisch leitfähigen Material besteht und Folgendes umfasst:
einen Körper (20);
wobei der Körper um eine Mittelachse zentriert ist, die sich in einer axialen Richtung von einer ersten Außenfläche (30) des Körpers zu einer zweiten Außenfläche (40) des Körpers erstreckt;
wobei sich mindestens eine dritte Außenfläche (50) des Körpers von der ersten Außenfläche zur zweiten Außenfläche erstreckt; und
wobei sich mindestens ein Luftkanal (60) durch den Körper von der ersten Außenfläche zur zweiten Außenfläche erstreckt und innerhalb des Körpers angeordnet ist, wobei der mindestens eine Luftkanal von der mindestens einen dritten Außenfläche umgeben ist, wobei der mindestens eine Luftkanal eine gerippte Fläche umfasst, wobei sich die gerippte Fläche von der ersten Außenfläche zur zweiten Außenfläche erstreckt;
wobei der mindestens eine Luftkanal mindestens einen bogenförmigen Luftkanal umfasst; und
wobei der mindestens eine bogenförmige Luftkanal einen entlang der Mittelachse zentrierten Krümmungsradius aufweist.

2. Kühlkörper gemäß Anspruch 1, wobei die gerippte Fläche Rippen umfasst, die sich in axialer Richtung erstrecken.

3. Kühlkörper gemäß einem der Ansprüche 1-2, wobei der mindestens eine Luftkanal einen Luftkanal umfasst, der sich entlang der Mittelachse des Körpers erstreckt.

4. Kühlkörper gemäß einem der Ansprüche 1-3, wobei der mindestens eine bogenförmige Luftkanal eine Vielzahl von Luftkanälen umfasst, wobei jeder der Vielzahl von Luftkanälen einen unterschiedlichen Krümmungsradius aufweist, der entlang der Mittelachse zentriert ist.

5. Kühlkörper gemäß einem der Ansprüche 1-4, wobei mindestens ein Teil einer Verbindungsstelle (70) zwischen der mindestens einen dritten Außenfläche und der ersten Außenfläche einen konvex abgerundeten Abschnitt aufweist.

6. Kühlkörper gemäß einem der Ansprüche 1-5, wobei mindestens ein Teil einer Verbindungsstelle (80) zwischen der mindestens einen dritten Außenfläche und der zweiten Außenfläche einen konvex abgerundeten Abschnitt aufweist.

7. Kühlkörper gemäß einem der Ansprüche 1-6, wobei die mindestens eine dritte Außenfläche einen ebenen Abschnitt (90) umfasst, wobei der ebene Abschnitt dazu ausgelegt ist, an einem oder mehreren Komponenten eines Hochspannungs-Schaltgeräts angebracht zu werden.

8. Kühlkörper gemäß einem der Ansprüche 1-7, wobei die mindestens eine dritte Außenfläche eine im Wesentlichen zylindrische Form mit einem entlang der Mittelachse zentrierten Krümmungsradius aufweist.

9. Kühlkörper gemäß einem der Ansprüche 1-8, wobei der Körper aus Aluminium besteht.

10. Kühlkörper gemäß einem der Ansprüche 1-9, wobei der Körper durch Hohlstrangpressen hergestellt ist.

11. Kühlkörper gemäß Anspruch 10, wobei die mindestens eine dritte Außenfläche eine gerippte Fläche umfasst.

12. Mittel- oder Hochspannungs-Schaltgerät, das mindestens einen Kühlkörper gemäß einem der Ansprüche 1-11 umfasst.

## Revendications

1. Dissipateur thermique (10) pour un dispositif de commutation haute tension, le dissipateur thermique étant configuré pour refroidir des parties moyenne et haute tension du dispositif de commutation et le dissipateur thermique étant constitué d'un matériau électroconducteur et comprenant :
un corps (20) ;
dans lequel le corps est centré autour d'un axe central qui s'étend dans une direction axiale d'une première surface externe (30) du corps à une deuxième surface externe (40) du corps ;
dans lequel au moins une troisième surface externe (50) du corps s'étend de la première surface externe à la deuxième surface externe ; et
dans lequel au moins un canal d'air (60) s'étend à travers le corps de la première surface externe à la deuxième surface externe et est situé à l'intérieur du corps, dans lequel l'au moins un canal d'air est entouré par l'au moins une troisième surface externe, dans lequel l'au moins un canal d'air comprend une surface nervurée, dans lequel la surface nervurée s'étend de la première surface externe à la deuxième surface externe ;
dans lequel l'au moins un canal d'air comprend au moins un canal d'air de forme arquée ; et
dans lequel l'au moins un canal d'air arqué a un rayon de courbure centré le long de l'axe central.

2. Dissipateur thermique selon la revendication 1, dans lequel la surface nervurée comprend des ailettes qui s'étendent dans la direction axiale.

3. Dissipateur thermique selon l'une quelconque des revendications 1 à 2, dans lequel l'au moins un canal d'air comprend un canal d'air s'étendant vers le bas de l'axe central du corps.

4. Dissipateur thermique selon l'une quelconque des revendications 1 à 3, dans lequel l'au moins un canal d'air arqué comprend une pluralité de canaux d'air, dans lequel chacun de la pluralité de canaux d'air a un rayon de courbure différent centré le long de l'axe central.

5. Dissipateur thermique selon l'une quelconque des revendications 1 à 4, dans lequel au moins une partie d'une jonction (70) entre l'au moins une troisième surface externe et la première surface externe a une partie arrondie convexe.

6. Dissipateur thermique selon l'une quelconque des revendications 1 à 5, dans lequel au moins une partie d'une jonction (80) entre l'au moins une troisième surface externe et la deuxième surface externe a une partie arrondie convexe.

7. Dissipateur thermique selon l'une quelconque des revendications 1 à 6, dans lequel l'au moins une troisième surface externe comprend une partie plate (90), dans lequel la partie plate est configurée pour être montée sur un ou plusieurs composants d'un dispositif de commutation haute tension.

8. Dissipateur thermique selon l'une quelconque des revendications 1 à 7, dans lequel l'au moins une troisième surface externe a une forme sensiblement cylindrique, avec un rayon de courbure centré le long de l'axe central.

9. Dissipateur thermique selon l'une quelconque des revendications 1 à 8, dans lequel le corps est constitué d'aluminium.

10. Dissipateur thermique selon l'une quelconque des revendications 1 à 9, dans lequel le corps est fabriqué par extrusion creuse.

11. Dissipateur thermique selon la revendication 10, dans lequel l'au moins une troisième surface externe comprend une surface nervurée.

12. Dispositif de commutation moyenne ou haute tension comprenant au moins un dissipateur thermique selon l'une quelconque des revendications 1 à 11.
